# FASCICULE DE BREVET EUROPEEN

(11) **EP 2 289 068 B1**
(45) Date de publication et mention de la délivrance du brevet: **28.03.2012**
(21) Numéro de dépôt: 09766089.8
(22) Date de dépôt: 18.06.2009
(51) Int. Cl.: G11C 5/00

(54) **DETECTION ET CORRECTION D'ERREURS POUR UNE MEMOIRE DONT LES ETATS DE BIT ONT UNE RESISTANCE D'ERREUR DIFFERENTE**
FEHLERERKENNUNG UND -KORREKTUR IN EINEM SPEICHER MIT VERSCHIEDENEN FEHLERRESISTENTEN BIT-STATUS
ERROR DETECTION AND CORRECTION IN A MEMORY WITH DIFFERENT ERRORRESISTANT BIT STATES

(30) Priorité: 19.06.2008 FR 0854055
(43) Date de publication de la demande: 02.03.2011
(73) Titulaire: European Aeronautic Defence and Space Company EADS France, 75016 Paris (FR); Astrium SAS, 75116 Paris (FR)
(72) Inventeur: MILLER, Florent, F-92300 LEVALLOIS PERRET (FR); CARRIERE, Thierry, F-78510 Triel sur Seine (FR); BOUGEROL, Antonin, F-92150 Suresnes (FR)
(74) Mandataire: Lotaut, Yacine Diaw
(86) Numéro de dépôt international: PCT/FR2009/051165
(87) Numéro de publication internationale: WO 2009/153527

(56) Documents cités:
- US-A- 5 200 963
- US-A1- 2004 066 690
- US-B1- 6 668 341
- US-B1- 6 785 169

## Description

La présente invention a pour objet un procédé de détection et de correction d'erreurs pour des mémoires électroniques, dont le point mémoire est à comportement de mémorisation dissymétrique. Le procédé permet d'utiliser des mémoires électroniques commerciales, et non spécifiquement protégées, malgré leur sensibilité aux interactions énergétiques externes, dans des applications aéronautiques ou spatiales. Elle est applicable à toutes les familles de mémoires à base de semi-conducteurs ayant un comportement dissymétrique, embarquées sur des systèmes amenés à évoluer dans des environnements perturbés par des radiations naturelles ou artificielles.

Dans le cas de l'environnement radiatif naturel, un effet dont l'invention protège est appelé un effet singulier. Il s'agit d'un effet non destructif, se traduisant par l'inversion d'une ou plusieurs informations logiques stockées dans une mémoire électronique. Des effets de ce type sont provoqués par l'apport de charges électriques suite au passage d'une particule ionisante, de façon directe ou non.

A l'heure actuelle, un certain nombre de techniques de détection et de corrections d'erreurs existent et sont mises en oeuvre pour adresser cette problématique. Néanmoins leur efficacité est proportionnelle à leur complexité et leur coût. C'est pourquoi leur utilisation est souvent restreinte aux éléments les plus critiques d'un système. L'information unitaire, appelé bit, est binaire et peut prendre la valeur '1' ou '0'. On appelle mot un ensemble de plusieurs bits. Les critères déterminant l'efficacité d'une technique de détection et de correction d'erreurs sont le nombre de bits en erreur pouvant être détectés dans un mot, le nombre de bits en erreur pouvant être corrigés, le temps de traitement ainsi que la quantité de ressource nécessaire pour effectuer ces détections et corrections. Le rendement R est le rapport du nombre de bits à corriger sur le nombre de bit à stocker.

Par ordre de complexité, on distingue différentes techniques de détection et de correction. La technique des codes de parité permet la détection d'une unique erreur dans un mot. Pour une information codée sur n bits, un bit supplémentaire est stocké. Cette technique ne permet pas la correction de l'erreur. La technique des codes de Hamming permet la détection de deux erreurs et la correction d'une erreur dans un mot. Le Code de Hamming (11,7), par exemple, permet ainsi de protéger une information de 7 bits en ajoutant 4 bits supplémentaires. Ce code est celui dont le rendement, c'est à dire le nombre de bits transmis par rapport au nombre de bits utiles, est maximal dans le cadre de la correction d'un bit unique dans un mot.

La technique des codes Reed Salomon corrige plusieurs erreurs au sein d'un même mot. Pour une information de N bits et pour corriger K bits, il est nécessaire de stocker N + 2K bits. Ainsi pour corriger l'intégralité des N bits d'un mot, il est nécessaire de stocker 3 x N bits. Le rendement est donc R = 1/3.

La technique de triplication utilise une triple redondance, c'est à dire que chaque donnée est stockée en trois exemplaires. Un élément de type voteur compare les trois données et sélectionne la valeur apparaissant au moins deux fois. Comme dans la technique précédente, pour protéger les N bits d'un mot, il est nécessaire de stocker 3 x N bits. Le rendement est donc aussi R = 1/3.

Actuellement, les systèmes protégeant l'intégralité des bits d'un mot nécessitent donc au minimum de stocker trois fois plus d'informations, soit un rendement R = 1/3. L'invention proposée est une technique permettant de détecter et de corriger l'intégralité des bits d'un mot, quelle que soit sa longueur, et nécessitant moins de stockage de bits supplémentaires que les techniques existantes, le rendement étant proche de R = 1/2.

L'invention repose sur une propriété intrinsèque à certaines familles de mémoires électroniques, pour lesquelles on constate un comportement dissymétrique, ou asymétrique, de la structure de mémorisation, et pour lesquelles un des deux états possibles est insensible aux perturbations externes.

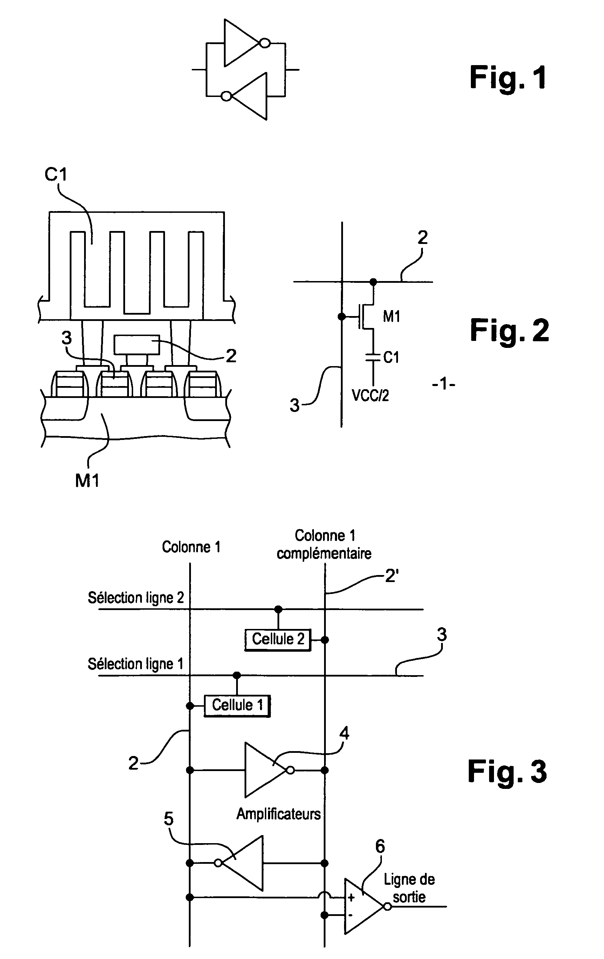

On parle de mémoire à comportement symétrique lorsque l'information est stockée dans une structure symétrique, comme c'est le cas par exemple dans un point mémoire SRAM, mettant en oeuvre deux inverseurs rétrocouplés. La figure 1 montre à cet égard un point mémoire SRAM, structure symétrique.

Au contraire, on entend par mémoire à comportement dissymétrique, les mémoires pour lesquelles l'information logique est stockée dans une structure non symétrique comme par exemple une capacité qui stocke une quantité de charges électriques, ou un transistor qui stocke une quantité de charges électriques dans sa grille flottante.

L'invention s'applique indifféremment aux mémoires de type volatile et non-volatile. On entend par mémoire volatile les mémoires qui perdent l'information stockée lors d'une mise hors tension. A l'inverse, on désigne par mémoire non volatile une mémoire qui garde l'information lors de sa mise hors tension.

Parmi les mémoires à comportement dissymétrique et volatile, on peut citer à titre d'exemple la famille des mémoires DRAM, mémoires dynamiques à accès aléatoire (VDRAM, RDRAM, XDR DRAM, DRAM EDO, DDR, DDR2, DDR3, eDRAM, DRAM FPM...), pour lesquelles l'information logique est stockée dans une structure capacitive. L'information stockée peut être un '1' ou un '0' logique, selon que la capacité soit chargée ou non.

La figure 2 montre en coupe un exemple d'une structure, ainsi que la représentation schématique associée, pour un point mémoire DRAM. Ce point mémoire 1 comporte un condensateur C1 relié par un transistor M1 à une ligne de bits 2. Le transistor M1 est commandé par une ligne de mots 3 reliée à sa grille. Le potentiel de l'armature du condensateur relié au transistor M1 est porté à VCC lorsque le point mémoire mémorise un 1. Il est porté à celui de la masse lorsqu'il mémorise un 0. Les mémoires à comportement dissymétrique et non volatiles sont celles de la famille des EPROMs et des FLASHs avec un transistor à grille flottante comme élément de mémorisation.

L'invention s'applique pour les mémoires citées ci-dessus, qu'elles soient à cellule unique ou multiple. On appelle mémoire à cellule unique une mémoire stockant une information binaire par structure physique. On appelle mémoire à cellule multiple une mémoire stockant plusieurs informations binaires dans une même structure physique.

On appelle état, au sens d'état électrique, un état physique d'une cellule, par exemple une cellule avec des électrons stockés ou non sur une armature concernée d'un condensateur d'une mémoire DRAM, ou avec des électrons stockés ou non dans la grille flottante d'un transistor à grille flottante d'une EPROM ou d'une FLASH.

On appelle information binaire, fondamentalement dépendant d'un protocole de lecture, d'un mode de lecture, un état logique, par opposition à un état électrique, dont la valeur est 1 ou 0. Selon qu'on est en logique positive ou en logique négative, un même état électrique, des électrons stockés sur une plaque de condensateur ou dans une grille flottante, peuvent correspondre à deux états logiques différents.

La propriété physique utilisée est l'insensibilité face à la collection de charges parasites d'un des deux états possibles d'une cellule mémoire à comportement dissymétrique. Autrement dit c'est la particularité pour ce type de cellule de n'avoir qu'un seul état assujetti aux perturbations externes. L'état opposé étant donc insensible.

Par exemple, pour les mémoires DRAM, dont l'information binaire est traduite par la présence ou l'absence de charges électriques, dans le cas où la cellule a sa capacité chargée, l'adjonction de charges supplémentaires induites par une agression extérieure n'aura pas d'effets car la cellule ne pourra contenir de charges plus importantes que celles qu'elle contient déjà. Même si la cellule n'est pas complètement chargées, l'effet sera un renforcement de son état logique. Son état chargé sera donc l'état d'insensibilité, et son état déchargé sera l'état sensible. Les charges collectées par une agression extérieure étant des électrons pour un transistor NMOS, l'état d'insensibilité est donc celui pour lequel la capacité est chargée de manière négative, et est donc celui dans lequel l'armature reliée au transistor M1 est chargée d'électrons. Pour un transistor PMOS ce sont les trous qui sont collecté, le raisonnement inverse est donc appliqué.

La mise en oeuvre de l'invention tient compte aussi d'une autre propriété inhérente à la construction de circuits périphériques. Cette propriété est la lecture d'un état logique opposé à l'état physique pour la moitié des cellules mémoires: celles reliées à des colonnes complémentaires.

On parlera ainsi de deux modes de lectures. Un premier mode est à logique positive. Ce premier mode interprète, par exemple pour une première partie des cellules de la mémoire, la présence des électrons comme un premier état binaire donné. Alors qu'un deuxième mode est à logique négative. Ce deuxième mode interprète, par exemple pour une deuxième partie des cellules de la mémoire, la présence des mêmes électrons comme un deuxième état binaire donné, complémentaire du premier.

La conséquence est l'équiprobabilité pour une cellule donnée et pour un état donné d'être lue comme un '1' logique ou un '0' logique.

Afin d'illustrer cet aspect, la figure 3 permet une description du cycle de lecture d'une cellule de type DRAM entière. Par construction, chaque cellule, Cellule 1 et Cellule 2 est reliée à une ligne (ligne de mots), et à une colonne (colonne de bits). Les colonnes fonctionnent par paires.

Dans un premier temps, les deux colonnes 2 et 2', celles attachées à la Cellule 1 et à sa complémentaire Cellule 2, sont pré chargées à un niveau de tension connu. Lorsque la ligne de mots 3 de la cellule est sélectionnée, il y transfert de charges entre la Cellule 1 et sa colonne 2, ce qui engendre une variation de la tension de la colonne. Cette variation (positive ou négative) est de l'ordre de la dizaine de millivolts. Cette tension est alors comparée à celle de la colonne complémentaire, et des amplificateurs 4 et 5 sont activés pour accroitre la différence. Le signal arrive ensuite sur une des deux entrées d'un amplificateur 6 différentiel, chargé de délivrer une tension logique. Si la tension de son entrée positive et supérieure à celle de son entrée négative, la sortie logique sera '1'. Dans le cas contraire, la sortie sera '0'.

Ainsi par sa conception, l'amplificateur différentiel inverse systématiquement la valeur de son entrée négative, celle reliée aux colonnes complémentaires.

La présente invention préconise ainsi l'utilisation d'une propriété intrinsèque aux mémoires électroniques commerciales à structure dissymétrique, à savoir, l'insensibilité aux agressions externes d'un de leurs deux états. Cette insensibilité permet de concevoir des architectures mémoires tolérantes aux perturbations provoquées par l'environnement radiatif naturel.

Le document US 6,785,169 B1 divulgue une mémoire selon le préambule de la revendication 1. Il décrit une mémoire à comportement dissymétrique dont la détection et la correction d'erreur de bits sont effectuées par un circuit de comparaison qui est une porte logique. Pour ce faire, la mémoire comporte une cellule mémoire originale et une cellule mémoire miroir. Le circuit logique effectue une comparaison binaire (bit par bit) des deux cellules pour détecter une erreur.

De façon générale, l'invention s'applique à tout composant à comportement dissymétrique, pour lesquels il existe une structure périodique identique ou complémentaire.

L'invention met en oeuvre un procédé de détection et de correction d'erreurs basé sur la duplication des données à protéger, chacune étant inscrites sur une structure distincte, associée à une référence du motif d'insensibilité de ces mêmes structures.

L'illustration du principe élémentaire met en oeuvre trois structures composées de cellules uniques, avec une duplication et une référence de motif d'insensibilité.

Selon l'invention, quel que soit le mode de lecture, il importe qu'un état électrique d'une référence soit dans un état qui n'a pas pu changer du fait de l'agression. Typiquement si des électrons sont diffusés dans un composant, du fait d'une agression ionique ou photonique, ces électrons peuvent aller se stocker n'importe où. Ils peuvent donc aller aussi se stocker dans une cellule mémoire de référence. Si cette dernière est dans un état où elle possède déjà des électrons stockés, d'en avoir un peu plus ne change pas son état électrique, ni son état logique. Avec un tel choix, la référence est insensible aux agressions extérieures. La référence, indique aussi, selon son état électrique lu quel était l'état électrique qui n'a pas pu changer.

L'invention est définit par les revendications 1 et 8.

L'invention sera mieux comprise à la lecture de la description qui suit et à l'examen des figures qui l'accompagnent. Celles ci ne sont présentées qu'à titre indicatif et nullement limitatif de l'invention. Les figures montrent :
- figure 1 : déjà commentée, un point mémoire SRAM, structure symétrique ;
- figure 2 : déjà commentée, une vue en coupe d'un exemple d'une structure dissymétrique, ainsi que la représentation schématique associée pour un point mémoire DRAM ;
- figure 3 : déjà commentée un cycle de lecture d'une cellule de type DRAM entière ;
- figures 4 et 5 : trois structures identiques à comportement dissymétrique montrant un principe élémentaire de l'invention, avec un mode de lecture positif et négatif respectivement ;
- figure 6 : différentes possibilités d'erreur, et des corrections associées en fonction d'un motif de référence ;
- figure 7 : un exemple de configuration mono-boitier dans lequel une subdivision est une banque ;
- figure 8 : le même exemple avec une colonne 0 prise comme colonne de motif de référence ;
- figure 9 : un principe d'architecture multi-boitier tolérante aux fautes ;
- figure 10 : une représentation schématique de la logique de détection et de correction d'erreur.

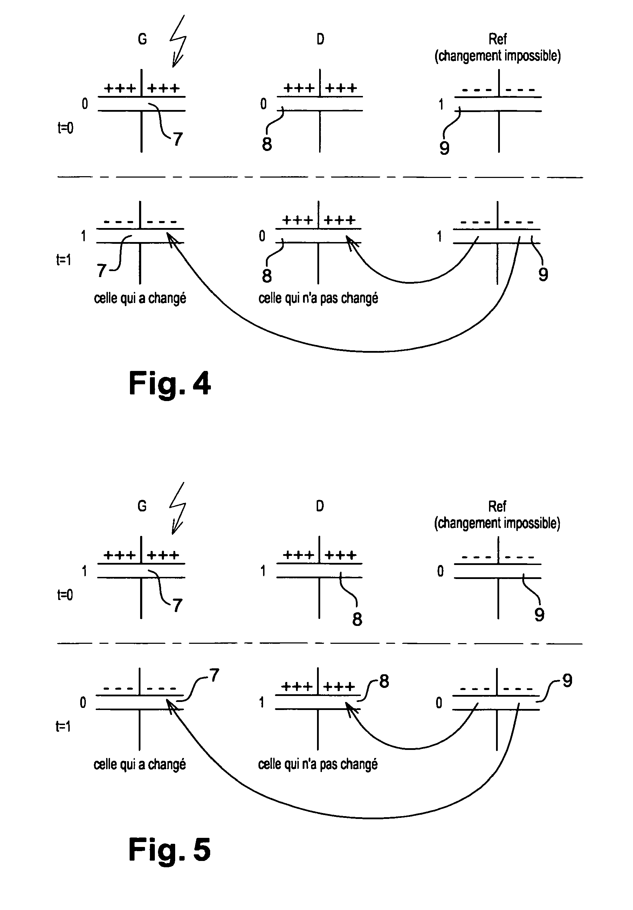

Ainsi figure 4, partie haute, on a montré schématiquement une cellule 7 (de DRAM) couplée à une cellule 8 de DRAM. La mémoire DRAM en question est une mémoire dont les cellules adoptent un comportement dissymétrique. Il en serait de même pour toutes les autres catégories de DRAM, de même que pour des EPROM, et plus généralement pour toutes les mémoires dont le comportement électronique des cellules n'est pas symétrique. Les cellules 7 et 8 sont couplées en ce sens qu'elles doivent stocker une même information. Les cellules 7 et 8 sont situées à différents endroits de la mémoire, par exemple sur une même ligne de mot, mais ici l'une dans un demi-plan gauche G du plan mémoire, l'autre dans un demi-plan droit D du plan mémoire du composant. Le fait d'avoir deux cellules pour mémoriser une même information montre déjà que le rendement de mémorisation est 1/2, il y a une redondance. Le couplage des deux cellules peut être plus complexe, par exemple leurs mots d'adresse peuvent être complémentaires. Dans tous les cas, elles doivent mémoriser une information cohérente.

Avec les conventions évoquées ci-dessus, et pour un mode de lecture donné, les deux cellules 7 et 8 stockent un état logique binaire 0, symbolisé par des + présents sur l'armature du condensateur. Cet état électrique est un état fragile en ce sens qu'il est susceptible de changer. En effet, c'est ce qui se produit après une agression, montrée figure 4 dans la partie inférieure, sous les tirets, où des électrons sont venus altérer l'état physique de la cellule 7 du demi-plan gauche, dont l'état électrique + s'est dégradé en un état électrique - (dont la lecture révèlerait un 1 logique).

La cellule 9 de référence, affectée à ce couple de cellules 7 et 8 est normalement dans un état électrique insensible aux agressions. Le condensateur stocke des électrons, et avec le mode de lecture retenu, il indique un 1 logique. La cellule 9, même si elle a été agressée, ne peut donc pas avoir changé ni d'état électrique, ni d'état logique.

Avec un détecteur, avant de valider la lecture des cellules 7 et 8, on vérifie qu'elles indiquent des états logiques cohérents. Par cohérent, on entend que les deux cellules, hors agression, doivent indiquer un même état logique final. Soit, comme montré figures 4, et 5, les cellules d'un couple 7 et 8 sont lues toutes les deux avec un même mode de lecture (mode de lecture positif sur la figure 4, mode de lecture négatif sur la figure 5) soit, elles sont lues avec des modes complémentaires. Dans le cas où elles sont lues avec un même mode, figures 4 et 5, les cellules d'un couple sont dans un même état électrique pour désigner un même état logique. Dans le cas où elles sont lues avec des modes complémentaires, les cellules d'un couple sont dans des états électriques complémentaires pour désigner un même état logique.

Dans le cas de la figure 4, et de la figure 5, un état cohérent révélant des informations cohérentes est donc celui dans lequel les deux cellules 7 et 8 sont dans un même état électrique, donc, avec un même mode de lecture, dans un même état logique pour révéler ensemble un même état logique final. Sinon, elles sont dans un état contradictoire. C'est ce qui se passe pour le bas de la figure 4, et pour le bas de la figure 5, où un état contradictoire est détecté par un détecteur de validation de lecture. Le détecteur de validation de lecture est le détecteur, vu plus loin, qui permet de savoir si les informations lues sont cohérentes, si elles sont donc vraies toutes les deux, ou si elles sont contradictoires. Et dans ce cas une seule est vraie.

De cet état contradictoire, on déduit qu'une des deux informations est erronée. Sachant que la cellule de référence 9 est dans un état insensible, on peut déduire que seule la cellule 7, qui est dans un même état électrique que la cellule 9 a changé. En effet, la cellule 8 n'a pu passer d'un état électrique avec des charges - à un état électrique avec des charges +, puisque ce passage n'est pas possible sous l'effet d'agressions extérieures. Donc la cellule 8 est ici celle qui est dans un état vrai, la cellule 7, dont l'état électrique est celui de la cellule 9 de référence est dans un état faux.

Donc, avec ces déductions on peut facilement déclarer que la cellule 8 n'a pas changé, que la cellule 7 a changé, et que c'est la cellule 7, celle qui a changé, celle qui a rejoint l'état de la cellule de référence, qui est dans un état faux.

Pour la figure 5, avec lecture négative, la cellule de référence stocke toujours des électrons (présences de - sur le condensateur), mais son état logique est 0, au lieu, figure 4, d'être 1.

Dans les deux cas, lecture positive ou négative, l'état logique vrai au moment de la vérification est l'état opposé à l'état logique de la cellule de référence.

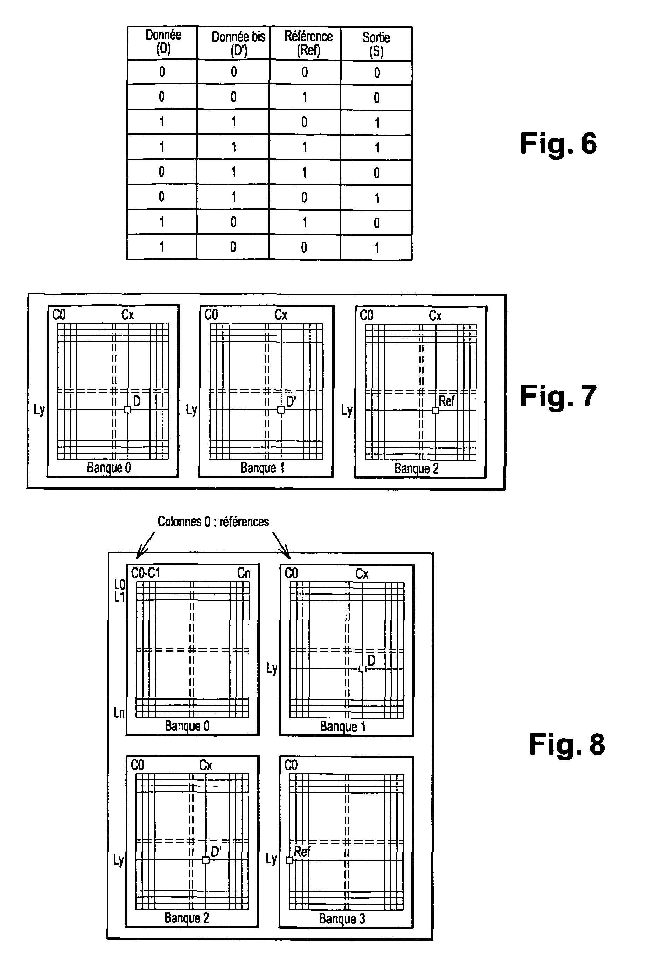

Au moment de la lecture, figure 6, si l'information (en logique positive comme sur la figure 4) est 0 et 0 sur les cellules 7 et 8, l'information vraie sera 0, quelle que soit la valeur de la cellule de référence, puisque ces 0 et 0 correspondent tous deux à des état insensibles. Il en est de même si ces état sont 1 et 1, puisqu'étant tous les deux sensibles, si aucun n'a changé, c'est que l'information vraie est celle du départ dans les deux cellules.

La troisième ligne du tableau de la figure 6 correspond à la figure 4 (sauf qu'on y montre que c'est la cellule du demi-plan droit qui a changé et non celle du demi-plan gauche). En effet, lorsque la référence se lit 1, c'est la cellule qui se lit 1 qui est fausse, et donc celle qui se lit 0 qui est vraie. La quatrième ligne du tableau correspond à la figure 5. En effet, lorsque la référence se lit 0, c'est la cellule qui se lit 0 qui est fausse, et donc celle qui se lit 1 qui est vraie. Les lignes 5 et 6 du tableau de la figure 6 montrent le cas ou l'autre cellule du couple a été affectée par l'agression.

L'architecture d'une mémoire réelle repose sur la division en différentes structures identiques de cellules mémoires. Chaque structure du plan mémoire contient un certain nombre d'emplacements mémoires désignés chacun par des coordonnées uniques, numéro de ligne et numéro de colonne.

Ces deux paramètres étant interchangeables, tout ce qui est désigné par ligne peut être remplacé par colonne, et réciproquement. De même, les concepts de l'invention sont similaires pour les structures périodiques identiques, et les structures périodiques complémentaires. Ainsi dans la suite du texte, les deux cas de figures sont applicables.

La division en éléments identiques assure qu'une cellule désignée par une même coordonnée au sein de chacun des éléments possède le même motif d'insensibilité.

Lors de la lecture, le mécanisme de détection d'erreur repose sur la simple comparaison des valeurs de D et D', lues sur les structures des figures 7 et 8, qui dont identiques en absence d'erreurs. Dans le cas d'une détection d'erreur, le mécanisme de correction est mit en oeuvre. Ce mécanisme de correction repose alors sur la connaissance du motif d'immunité: Ref, qui informe sur l'unique seul sens pour lequel une inversion du bit est possible et permet ainsi de retrouver la valeur initiale de la donnée.

La structure périodique peut alors être une adresse, un ensemble d'adresses, une ligne (ou une colonne), un ensemble de lignes (ou de colonnes), une banque, ou un ensemble de banques.

La question peut se poser de savoir combien il faut de cellule de référence. A titre d'exemple, la figure 7 propose qu'il y ait autant de cellules de référence qu'il y a de cellules dupliquées. Cette figure illustre un exemple de configuration mono-boitier dans laquelle la subdivision est une banque. On désigne par banque une matrice de lignes et de colonnes. Chaque emplacement ayant le même motif d'immunité au sein de chaque banque, des données D et D' sont dupliquées à des coordonnée similaires (Cx, Ly) respectivement dans la Banque 0 et la Banque 1. La Banque 2 est quant à elle réservée au stockage du motif d'insensibilité.

Ainsi la Banque 0 de données renferme les cellules telles que 7, la Banque 1 renferme les cellules tells que 8, et la Banque 2 enferme les cellules telles que 9 de référence. La figure 7, avec trois tiers plan mémoire dans un même composant se décline facilement en trois composants identiques juxtaposés. En effet, la taille de l'impact d'un rayonnement cosmique, ionique ou photonique est suffisamment petite pour imaginer qu'il atteint certaines cellules et pas d'autres dans un même plan mémoire, a fortiori dans des plans mémoires réalisés avec des composants différents juxtaposés ou empilés.

Les descriptions ci-dessus ont illustré le principe de l'invention avec un rendement R, pire cas, équivalent à la technique de triplication précédemment expliquée. Ainsi pour protéger N bits, il est nécessaire de stocker 3 x N bits. Le rendement est donc R = 1/3.

Pour des applications réelles, des architectures optimisées permettent d'obtenir des rendements proches de R = 1/2. Pour cela, il s'agit de réduire la quantité d'espace alloué au stockage du motif de référence.

Comme les architectures de plan mémoire ne sont pas communiquées par les constructeurs, il peut être difficile de mettre en oeuvre l'invention sachant que d'un plan mémoire à l'autre le mode de lecture peut changer. L'optimisation consiste donc à avoir une cellule de référence pour chaque structure périodique. Le rendement est alors défini par le nombre de structures périodiques. Moins il y a de structures différentes et plus le rendement est proche de 1/2.

Dans l'exemple suivant, figure 8, on pose le postulat que chaque ligne correspond à une structure périodique. Ainsi toutes les cellules possèdent le même motif d'insensibilité au sein d'une même ligne. Suivant ce postulat, il est ainsi possible d'utiliser comme motif de référence d'insensibilité une seule colonne pour chaque ligne.

Dans certains composants, le mode de lecture change alternativement d'une ligne à l'autre. Dans ce cas, il importe de placer une cellule de référence au début, en fin ou au milieu ou quelque part dans chaque ligne, figure 8, de façon à disposer de la référence qui permettra de désigner celle des cellules qui est dans un état vrai. Dans ce cas, même sans connaitre le mode de lecture, on sait qu'en cas de contradiction, la cellule qui est dans le même état logique que la cellule de référence est dans un état faux.

Les exemples d'architectures présentés ci-dessus adressent des configurations mémoires mono-boitier, n'utilisant qu'un seul composant en circuit intégré.

Un raisonnement identique peut être appliqué, notamment pour des micro-ordinateurs de type personnel, avec une architecture multi-boitier dans laquelle un certain nombre de composants identiques sont utilisés en parallèle. Dans ce cas, un des composants peut être spécifiquement utilisé comme référence des motifs d'insensibilité, les autres servant à la duplication des données.

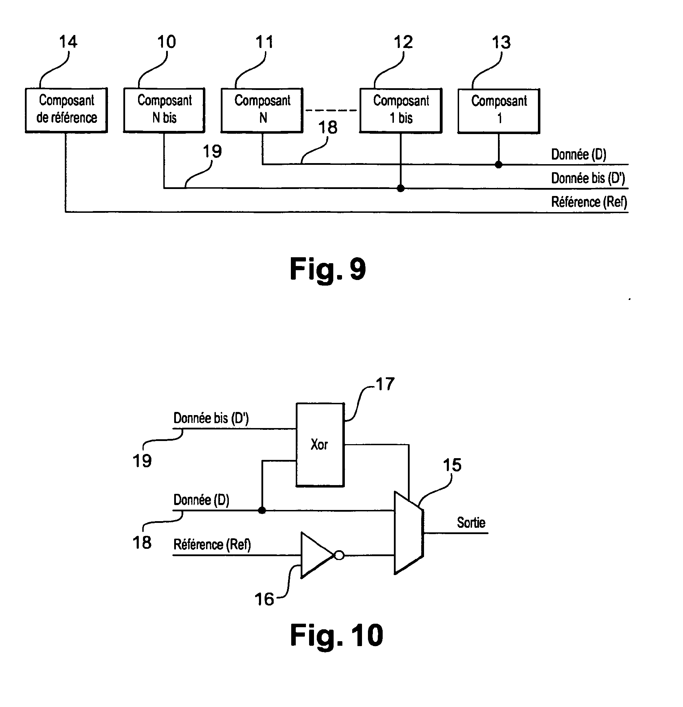

Cette configuration multi-boîtier est celle utilisée, figure 9 à titre d'exemple, où un certain nombre de boitiers 10-13 sont agencés en parallèle. La structure périodique identique est donc le composant lui-même relié à un bus de données. En effet, le motif d'insensibilité d'une mémoire est différent pour chaque référence et chaque nouvelle révision de circuits, mais il est en revanche identique pour un même lot de composants.

L'architecture proposée se base ainsi sur l'utilisation de plusieurs composants d'un même lot, qui pour une même adresse logique présenteront le même état d'insensibilité. L'architecture utilise un composant 14 dédié au stockage du motif de référence, tandis que les autres unités stockent les données dupliquées. Pour chaque bit du bus de données ci-dessus, un signal provient d'un composant principal, un deuxième provient du composant bis, et un troisième provient du composant de référence.

La figure 10 présente un exemple schématique d'un circuit logique électronique à réaliser pour une ligne de donnée. Ce circuit permet de détecter et de corriger instantanément l'erreur, sans interrompre un flot continu d'informations. Ce circuit logique est à placer sur les lignes du bus de données présenté figure 9. Il est constitué d'un multiplexeur 15, d'un inverseur 16 et d'une porte ou exclusif 17. La porte 17 reçoit les deux données D et D' et mesure si elles sont identiques. Si elles sont identiques la porte 17 actionne le multiplexeur 15 pour qu'il transmettre l'état de la donnée D. Sinon, selon ce qui a été vu plus haut, le multiplexeur 15 transmet l'inverse de l'état de la référence, puisqu'on a vu que la référence indiquait la cellule qui avait été perturbée et que c'était donc l'autre cellule qui est vraie, que c'est donc l'inverse de la référence qui est vraie, d'où l'inverseur 16.

Ainsi les lignes de bits 18 et 19 de ce type de mémoires sont reliées à ce détecteur 15-17 qui à la fois détecte l'erreur et la corrige. Les lignes de bits 18 et 19 sont ici matérialisées comme différenciées. Il serait toutefois possible d'avoir une seule ligne de bits commune pour les deux zones mémoire, la zone de base et la zone dupliquées, et par un multiplexeur de les lire à tour de rôle. Une même ligne serait ainsi équivalente à deux lignes.

Bien entendu, après avoir détecté une erreur on la corrige. En pratique on réécrit la donnée faussée avec l'inverse de la valeur lue dans la cellule de référence.

## Revendications

1. Mémoire comportant
- des cellules mémoires (7, 8, 12, 13), unique ou multiple, à comportement dissymétrique,
- un comportement dissymétrique résultant de la sensibilité d'une cellule mémoire dans un premier état électrique à changer d'état vers un deuxième état électrique lors d'une agression par irradiation, cette sensibilité étant moins grande pour passer du premier état au deuxième état que pour passer du deuxième état au premier état,
- des couples de cellules mémoires formés par ces cellules mémoires à comportement dissymétrique,
- une première cellule (7) d'un couple étant chargée d'une première information binaire et une deuxième cellule (8) du couple étant chargée d'une deuxième information binaire,
- un détecteur (17) pour détecter que les cellules mémoires d'un couple sont chargées de deux informations contradictoires au lieu de deux informations cohérentes, et
**caractérisée en ce qu'**elle comporte
- une cellule mémoire de référence (9, 14) chargée d'une information correspondant au premier état électrique insensible aux agressions, cet état électrique correspondant à un état logique où l'information binaire est fausse,
- un circuit logique pour désigner celle des cellules mémoires du couple qui est dans le deuxième état électrique correspondant à un état logique où l'information binaire est vraie, lorsque les états électriques des deux cellules sont contradictoires, en fonction de l'état électrique de la cellule mémoire de référence.

2. Mémoire selon la revendication 1, **caractérisée en ce que**
- la deuxième information correspond à un même état électrique que celui de la première information pour que ces informations soient cohérentes,
- des informations contradictoires étant alors des informations correspondant à des états électriques complémentaires.

3. Mémoire selon la revendication 1, **caractérisée en ce que**
- la deuxième information correspond à un état électrique complémentaire de celui de la première information pour que ces informations soient cohérentes,
- des informations contradictoires étant alors des informations correspondant à des mêmes états électriques.

4. Mémoire selon l'une des revendications 1 à 3, **caractérisée en ce que**
- le détecteur détecte celle des cellules qui a changé d'état du fait de l'irradiation, et
- un circuit logique désigne l'autre cellule comme étant la cellule dans un état vrai.

5. Mémoire selon l'une des revendications 1 à 4, **caractérisée en ce qu'**elle est du type DRAM ou EPROM.

6. Mémoire selon l'une des revendications 1 à 4, **caractérisée en ce qu'**elle comporte
- des lignes de bits reliées à des cellules mémoires dupliquées,
- une porte ou exclusif reliée à ces lignes de bits
- un duplexeur commandé par cette porte ou exclusif,
- ce duplexeur recevant en entrée une de ces lignes de bits et une ligne de bit provenant de la cellule de référence.

7. Utilisation d'une mémoire selon l'une des revendications 1 à 6 dans un ordinateur de type personnel.

8. Procédé de détection et de correction d'erreur de données mémorisées dans une mémoire dont le point mémoire est à comportement dissymétrique dans lequel
- on mémorise les données à corriger dans deux banques de données,
- on détecte une erreur dans une banque et
- on la corrige avec le contenu de l'autre banque,
**caractérisé en ce que**
- un comportement dissymétrique résultant de la sensibilité d'une cellule mémoire dans un premier état électrique à changer d'état vers un deuxième état électrique lors d'une agression par irradiation, cette sensibilité étant moins grande pour passer du premier état au deuxième état que pour passer du deuxième état au premier état,
- on forme des couples de cellules mémoires à l'aide de cellules mémoires à comportement dissymétrique dans deux des banques,
- une première cellule d'un couple étant chargée d'une première information binaire et une deuxième cellule du couple étant chargée d'une deuxième information binaire,
- on mémorise dans une cellule mémoire de référence une information correspondant au premier état électrique insensible aux agressions, cet état électrique correspondant à un état logique où l'information binaire est fausse,
- on détecte que les cellules mémoires d'un couple sont chargées de deux informations contradictoires au lieu de deux informations cohérentes, et
- on désigne à l'aide d'un circuit logique, en fonction de la cellule mémoire de référence, celle des cellules mémoires du couple qui est dans le deuxiéme état électrique correspondant à un état logique où l'information binaire est vraie, lorsque les états électriques des deux cellules sont contradictoires.

9. Procédé selon la revendication 8, **caractérisé en ce qu'**après avoir détecté une erreur on la corrige.

## Claims

1. A memory comprising
- single or multiple memory cells (7 ; 8 ; 12 ; 13) with asymmetrical behaviour,
- an asymmetrical behaviour resulting from the sensitivity of a memory cell in a first electrical state to change state to a second electrical state upon an attack by irradiation, this sensitivity being lower when passing from the first state to the second state than when passing from the second state to the first state,
- couples of memory cells formed by these memory cells with asymmetrical behaviour,
- a first cell (7) of a couple being loaded with a first piece of binary information and a second cell (8) of the couple being loaded with a second piece of binary information,
- a detector (17) to detect when the memory cells of a couple are loaded with two contradictory pieces of information instead of two consistent pieces of information, and
**characterized in that** it comprises
- a reference memory cell (9 ; 14) loaded with a piece of information corresponding to the first electrical state that is insensitive to attacks, this electrical state corresponding to a logic state where the binary information is false,
- a logic circuit to designate which of the memory cells of the couple is in the second electrical state corresponding to a logic state where the binary information is true, when the electrical states of the two cells are contradictory, according to the electrical state of the reference memory cell.

2. A memory according to claim 1, **characterized in that**
- the second piece of information corresponds to the same electrical state as that of the first piece of information so that this information is consistent,
- contradictory pieces of information therefore being information corresponding to additional electrical states.

3. A memory according to claim 1, **characterized in that**
- the second piece of information corresponds to an additional electrical state to that of the first piece of information so that this information is consistent,
- contradictory pieces of information therefore being information corresponding to the same electrical states.

4. A memory according to one of claims 1 to 3, **characterized in that**
- the detector detects which of the cells has changed state after irradiation, and
- a logic circuit designates the other cell as being the cell in a true state.

5. A memory according to one of claims 1 to 4, **characterized in that** it is a DRAM or EPROM-type memory.

6. A memory according to one of claims 1 to 4, **characterized in that** it comprises
- bit lines connected to duplicate memory cells,
- an exclusive OR gate connected to these bit lines
- a duplexer controlled by this exclusive OR gate,
- this duplexer receiving one of these bit lines as input in addition to one bit line originating from the reference cell .

7. The use of a memory according to one of claims 1 to 6 in a personal-type computer.

8. A method for detecting and correcting an error in data stored within a memory, the memory point of which behaves asymmetrically, wherein
- the data to be corrected is stored in two data banks,
- an error in a data bank is detected, and
- this error is corrected with the contents of the other data bank,
**characterized in that**
- an asymmetrical behaviour resulting from the sensitivity of a memory cell in a first electrical state to change state to a second electrical state upon an attack by irradiation, this sensitivity being lower when passing from the first state to the second state than when passing from the second state to the first state,
- couples of memory cells are formed by memory cells with asymmetrical behaviour in two of said banks,
- a first cell of a couple being loaded with a first piece of binary information and a second cell of the couple being loaded with a second piece of binary information,
- a piece of information corresponding to the first electrical state insensitive to attack is stored in a reference memory cell, said electric state corresponding to a logical state wherein the binary information is false,
- it is detected when the memory cells of a couple are loaded with two contradictory pieces of information instead of two consistent pieces of information, and
- using a logic circuit and according to the reference memory cell, it is designated which of the memory cells of the couple is the second state corresponding to a logical state wherein the binary information is true, when the electrical states of two said cells are contradictory.

9. A method according to claim 8, **characterized in that** after detection, an error is corrected.

## Patentansprüche

1. Speicher, umfassend
- Speicherzellen (7 ; 8 ; 12 ; 13), einzeln oder mehrfach, mit asymmetrischem Verhalten,
- ein asymmetrisches Verhalten resultierend aus der Empfindlichkeit einer Speicherzelle in einem ersten elektrischen Zustand, der bei einer Aggression durch Bestrahlen in einen zweiten elektrischen Zustand zu wechseln ist, wobei diese Empfindlichkeit beim Übergang vom ersten Zustand in den zweiten Zustand geringer ist, als beim Übergang vom zweiten Zustand in den ersten Zustand,
- Speicherzellenpaare, die durch diese Speicherzellen mit asymmetrischem Verhalten gebildet werden,
- eine erste Zelle (7) eines Paares, die mit einer ersten binären Information beladen wurde, und eine zweite Zelle (8) des Paares, die mit einer zweiten binären Information beladen wurde,
- einen Geber (17) zum Erfassen, ob die Speicherzellen eines Paares mit zwei widersprüchlichen Informationen anstatt mit zwei kohärenten Informationen beladen wurden, und
**dadurch gekennzeichnet, dass** er folgendes umfasst:
- eine Bezugs-Speicherzelle (9 ; 14), die mit einer Information entsprechend dem ersten elektrischen Zustand beladen wurde, der Aggressionen gegenüber unempfindlich ist, wobei dieser elektrische Zustand einem logischen Zustand entspricht, bei dem die binäre Information falsch ist,
- eine Logikschaltung zum Bezeichnen jener der Speicherzellen des Paares, die in einem zweiten elektrischen Zustand ist, der einem logischen Zustand entspricht, bei dem die binäre Information wahr ist, wenn die elektrischen Zustände der beiden Zellen in Abhängigkeit vom elektrischen Zustand der Bezugs-Speicherzelle widersprüchlich sind.

2. Speicher nach Anspruch 1, **dadurch gekennzeichnet, dass**
- die zweite Information einem selben elektrischen Zustand entspricht, wie jenem der ersten Information, damit diese Informationen kohärent sind,
- wobei widersprüchliche Informationen somit Informationen sind, die ergänzenden elektrischen Zuständen entsprechen.

3. Speicher nach Anspruch 1, **dadurch gekennzeichnet, dass**
- die zweite Information einem elektrischen Zustand entspricht, der gegenüber jenem der ersten Information ergänzend ist, damit diese Informationen kohärent sind,
- wobei widersprüchliche Informationen somit Informationen sind, die denselben elektrischen Zuständen entsprechen.

4. Speicher nach einem der Ansprüche 1 bis 3, **dadurch gekennzeichnet, dass**
- der Geber jene der Zellen erfasst, die ihren Zustand aufgrund der Bestrahlung geändert hat,
- eine Logikschaltung die andere Zelle als jene bezeichnet, deren Zustand wahr ist.

5. Speicher nach einem der Ansprüche 1 bis 4, **dadurch gekennzeichnet, dass** er vom Typ DRAM oder EPROM ist.

6. Speicher nach einem der Ansprüche 1 bis 4, **dadurch gekennzeichnet, dass** er folgendes umfasst:
- Bit-Zeilen, die mit duplizierten Speicherzellen verbunden sind,
- einen XOR Träger, der mit diesen Bit-Zeilen verbunden ist,
- einen Duplexer, der von diesem XOR Träger angesteuert wird,
- wobei dieser Duplexer als Eingang eine dieser Bit-Zeilen und eine Bit-Zeile aus der Bezugszelle erhält.

7. Verwendung eines Speichers nach einem der Ansprüche 1 bis 6 in einem Computer vom Typ PC.

8. Verfahren zum Erfassen und Korrigieren eines Fehlers in Daten, die in einem Speicher abgelegt sind, dessen Speicherpunkt ein asymmetrisches Verhalten aufweist, in dem
- man die zu korrigierenden Daten in zwei Datenbanken ablegt,
- man einen Fehler in einer Bank erfasst und
- man ihn mit dem Inhalt der anderen Bank korrigiert,
**dadurch gekennzeichnet, dass**
- ein asymmetrisches Verhalten resultierend aus der Empfindlichkeit einer Speicherzelle in einem ersten elektrischen Zustand, der bei einer Aggression durch Bestrahlen in einen zweiten elektrischen Zustand zu wechseln ist, wobei diese Empfindlichkeit beim Übergang vom ersten Zustand in den zweiten Zustand geringer ist, als beim Übergang vom zweiten Zustand in den ersten Zustand,
- man mithilfe dieser Speicherzellen mit asymmetrischem Verhalten in beiden der Banken Speicherzellenpaare bildet,
- eine erste Zelle eines Paares mit einer ersten binären Information, und eine zweite Zelle des Paares mit einer zweiten binären Information beladen wird,
- man in einer Bezugs-Speicherzelle eine Information entsprechend dem ersten elektrischen Zustand abspeichert, der Aggressionen gegenüber unempfindlich ist, wobei dieser elektrische Zustand einem logischen Zustand entspricht, bei dem die binäre Information falsch ist.
- man feststellt, ob die Speicherzellen eines Paares mit zwei widersprüchlichen Informationen anstelle von zwei kohärenten Informationen beladen werden, und
- man mithilfe einer Logikschaltung in Abhängigkeit von der Bezugs-Speicherzelle jene der Speicherzellen des Paares bestimmt, die sich in einem zweiten elektrischen Zustand befindet, der einem logischen Zustand entspricht, bei dem die binäre Information wahr ist, wenn die elektrischen Zustände der beiden Zellen widersprüchlich sind.

9. Verfahren nach Anspruch 8, **dadurch gekennzeichnet, dass** man einen Fehler nach dessen Erfassung korrigiert.
